# EUROPÄISCHE PATENTSCHRIFT

(11) **EP 4 411 789 B1**
(45) Veröffentlichungstag und Bekanntmachung des Hinweises auf die Patenterteilung: **13.08.2025**
(21) Anmeldenummer: 23154649.0
(22) Anmeldetag: 02.02.2023
(51) Int. Cl.: H01L 21/306

(54) **VERFAHREN ZUR REINIGUNG EINER HALBLEITERSCHEIBE**
METHOD OF CLEANING A SEMICONDUCTOR WAFER
PROCÉDÉ DE NETTOYAGE D'UNE PLAQUETTE SEMI-CONDUCTRICE

(43) Veröffentlichungstag der Anmeldung: 07.08.2024
(73) Patentinhaber: Siltronic AG, 81677 München (DE)
(72) Erfinder: Kühnstetter, Albert, 84489 Burghausen (DE); Brock, Damian, 84427 Sankt Wolfgang (DE)

(56) Entgegenhaltungen:
- EP-A1- 4 181 171
- US-A1- 2007 228 524
- US-A1- 2014 048 100

## Beschreibung

Gegenstand der Erfindung ist ein Verfahren zur Reinigung einer Halbleiterscheibe.

### Stand der Technik

Halbleiterscheiben, die beispielsweise als Substrate für die Herstellung mikroelektronischer Bauelemente dienen, meist Siliciumscheiben, werden nach dem Polieren, Beschichten (beispielsweise durch epitaktische Abscheidung) oder thermischen Behandlungsschritten (engl. "Annealing") bzw. vor Hochtemperaturprozessschritten mit nasschemischen Verfahren gereinigt.

Ziel der Reinigung ist es, Kontaminationen der Halbleiterscheiben, beispielsweise mit Metallen wie Kupfer oder mit organischen Substanzen, sowie an der Scheibenoberfläche haftende Partikel möglichst vollständig zu entfernen, da diese Kontaminationen bei der nachfolgenden Herstellung von Bauelementen zu Problemen führen, beispielsweise zu einem inhomogenen Aufwachsen der Gate-Oxide oder zu einem inhomogenen Abscheiden der Polysilicium-Gates.

In Anwendung sind dabei Einzelscheibenreinigungsverfahren, bei denen eine Halbleiterscheibe in eine schnelle Rotation um ihre Mittelachse versetzt wird und dabei zunächst mit einer oder mehreren Flüssigkeiten gereinigt, anschließend mit entionisiertem Wasser gespült und getrocknet wird. Die Flüssigkeiten werden auf die rotierende Halbleiterscheibe aufgebracht und durch die Zentrifugalkraft zum Scheibenrand hin beschleunigt, sodass die Flüssigkeiten nach außen abfließen und dabei auf der Scheibenoberfläche einen in der Regel ganzflächigen, dünnen Film bilden. Bei der anschließenden Trocknung unter weiterer Rotation der Halbleiterscheibe, beispielsweise unter Zugabe eines die Oberflächenspannung des Flüssigkeitsfilms reduzierenden Dampfes (z. B. von Isopropanol) fließt der Flüssigkeitsfilm vollständig nach außen ab. Derartige Verfahren sind beispielsweise in US 2004/0 103 915 A1 und EP 0 905 747 A1 beschrieben.

Aus der Schrift US 2007/228524 A1 ist ein Verfahren zum Reinigen von Halbleiterscheiben bekannt.

Aus der Schrift US 2014/048 100 A1 ist ein Verfahren zum Reinigen von Halbleiterscheiben bekannt, bei dem die folgenden Verfahrensschritte verwendet werden:
(1) ein erster Reinigungsschritt zum Reinigen mit ozonisiertem Wasser,
(2) ein zweiter Reinigungsschritt, der einen Behandlungsschritt mit ozonisiertem Wasser enthält, der gefolgt wird von einem Behandlungsschritt mit einer HF enthaltenden Flüssigkeit, wobei der zweite Reinigungsschritt mehrfach wiederholt werden kann,
(3) ein dritter Reinigungsschritt zum Reinigen mit ozonisiertem Wasser,
(4) ein Trocknungsschritt, bei dem die Seite der Halbleiterscheibe getrocknet wird.

Beim Test dieses Verfahrens haben die Erfinder entdeckt, dass Defektmuster auf dem Wafer auftreten können, die mit einer LLS Messung messbar sind. Diese Defekte treten offenbar bevorzugt im Zentrum des Substrates auf und können sich negativ auf das Verhalten der betroffenen Halbleiterscheiben im Fertigungsprozess für Bauelemente auswirken. Wird bei Verwendung dieses Verfahrens sowohl die eine als auch die andere Seite einer Halbleiterscheibe behandelt, treten zusätzliche Defekte im Randbereich der Halbleiterscheibe auf der jeweils gegenüberliegenden Seite auf. Wird beispielsweise die Rückseite einer Halbleiterscheibe mit diesem Verfahren gereinigt, können danach Partikel im Randbereich der Vorderseite auftreten, die störend für den Halbleiterbauelementprozess sein können.

Aufgabe der Erfindung ist es daher, ein Verfahren zur Verfügung zu stellen, das diese Defekte nicht verursacht, oder zumindest die Wahrscheinlichkeit des Auftretens dieser Defekte minimiert.

Die Aufgabe wird gelöst durch die in den Ansprüchen beschriebenen Verfahren.

### Kurzbeschreibung der Figuren

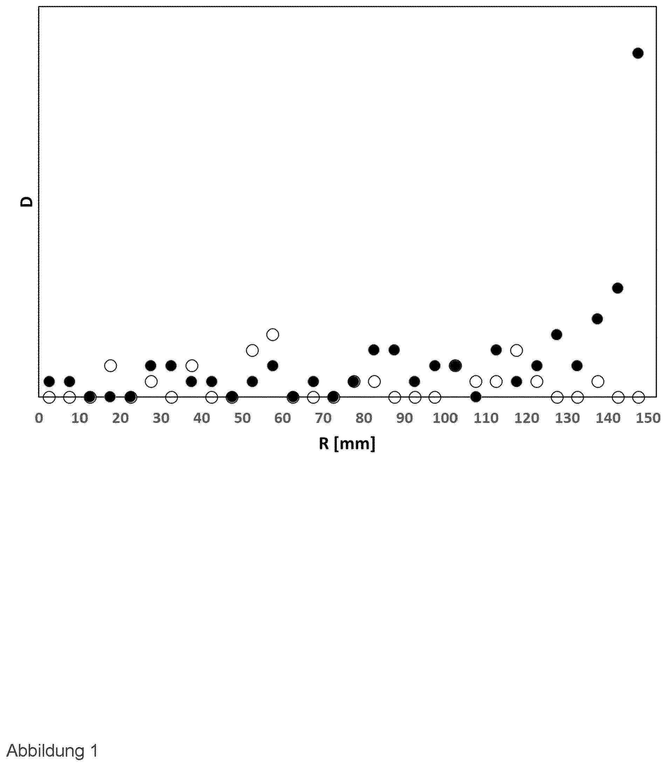

**Figur 1** zeigt als Illustration die Anzahl der Defekte D in relativen Einheiten als Funktion des Radius R der Halbleiterscheibe mit einem Nenndurchmesser von 300 mm. Die gefüllten Kreise stellen die Anzahl der Defekte dar, die erhalten werden, wenn nach dem Stand der Technik gereinigt wird. Die leeren Kreise stellen hingegen die Defekte dar, die erhalten werden, wenn nach dem erfinderischen Verfahren gereinigt wird. Deutlich ist zu erkennen, dass das erfinderische Verfahren am Rand der Halbleiterscheibe besser Defekte vermeiden mag als das Verfahren nach dem Stand der Technik.

### Abkürzungen

- **DIW**: deionisiertes Wasser. O3Wozonisiertes Wasser bestehend aus 15 - 20 ppm Ozon (O₃) gelöst in deionisiertem Wasser.
- **SC1**: "Standard Clean 1" enthaltend 0,3% Tetramethylammoniumhydroxid (TMAH, [N(CH₃)₄]OH ) und 0,7% Wasserstoffperoxid (H₂O₂) in deionisiertem Wasser.
- **HF**: 0,5% - 1% Fluorwasserstoff (HF) gelöst in deionisiertem Wasser.
- **DRY**: Trocknungsprozess, der in 100%-iger Stickstoffatmosphäre (N₂) durchgeführt wird.
- D: Anzahl der Defekte

### Detaillierte Beschreibung erfindungsgemäßer Ausführungsbeispiele

Beim Test eines Verfahrens aus dem Stand der Technik zum Reinigen von Halbleiterscheiben mittels einer Vorrichtung zum Reinigen von einzelnen Scheiben ("single wafer cleaner") haben die Erfinder festgestellt, dass Defektmuster auf dem Wafer auftreten können, die mit einer LLS Messung messbar sind.

Diese Defektmuster können durch eine Streulichtmessung (light scattering), beispielsweise mit einem Messgerät von KLA-Tencor unter Verwendung des Surfscan SP1 MX, sichtbar gemacht werden und wird daher auch als Localized Light Scattering-Belastung bezeichnet. WO 2005 101 483 A1 offenbart eine Methode zur Streulichtmessung bei epitaktisch beschichteten Halbleiterscheiben.

Wie **Abbildung 1** zeigt, treten diese Defekte bevorzugt am Rand der Halbleiterscheibe auf. Sie können sich negativ auf das Verhalten der betroffenen Halbleiterscheiben im Fertigungsprozess für Bauelemente auswirken.

Wird die Rückseite einer Halbleiterscheibe mit dem im Stand der Technik bekannten Verfahren gereinigt, weisen die Halbleiterscheiben im Randbereich der Vorderseite eine erhöhte Defektdichte auf. Diese Defekte konnten die Erfinder mit der genannten Messtechnik nachweisen.

Defekte sind nach der Reinigung weder auf der Vorder- noch Rückseite der Halbleiterscheibe tolerierbar und sind daher zu minimieren.

Bei dem Versuch, diese Defekte nicht auftreten zu lassen, haben die Erfinder entdeckt, dass es notwendig ist, zunächst die Vorderseite der Halbleiterscheibe zu reinigen und im Anschluss daran beide Seiten gemeinsam zu reinigen.

An der Vorderseite der Halbleiterscheibe wird erfindungsgemäß zuerst ein Vorreinigungsschritt durchgeführt, bei dem die Flüssigkeit im Wesentlichen aus Wasser besteht. Die Erfinder haben festgestellt, dass es essentiell ist, dass die Vorderseite noch nass sein muss, bevor der darauffolgende erste Reinigungsschritt zum Reinigen mit ozonisiertem Wasser mit anschließendem Spülschritt mit gereinigtem Wasser beginnt.

Erfindungsgemäß wird danach ein zweiter Reinigungsschritt durchgeführt, der einen Behandlungsschritt mit ozonisiertem Wasser enthält, der gefolgt wird von einem Behandlungsschritt mit einer HF enthaltenden Flüssigkeit.

Nach dem zweiten Reinigungsschritt wird erfindungsgemäß ein dritter Reinigungsschritt zum Reinigen mit ozonisiertem Wasser und anschließendem Spülschritt mit gereinigtem Wasser durchgeführt.

Danach wird erfindungsgemäß eine gemeinsame Reinigung der Vorderseite und der Rückseite der Halbleiterscheibe durchgeführt, die einen vierten Reinigungsschritt, der einen Behandlungsschritt mit ozonisiertem Wasser enthält, der gefolgt wird von einem Behandlungsschritt mit einer HF enthaltenden Flüssigkeit, und einen Trocknungsschritt, bei dem beide Seiten der Halbleiterscheibe getrocknet werden.

Bevorzugt wird während des Vorreinigungsschritts der Anteil von ozonisiertem Wasser von 0% am Anfang des Vorreinigungsschritts auf 100% am Ende des Vorreinigungsschritts gesteigert, wobei die Dauer mit einem Anteil kleiner als 5% kleiner ist als 10 s und größer ist als 1 s. Diese kontinuierliche Erhöhung des Anteils an ozonisiertem Wasser zwischen dem Vorreinigungsschritt hin zum ersten Reinigungsschritt bewirkt offenbar, dass die Anzahl der gefundenen Defekte noch weiter gesenkt wird.

Besonders bevorzugt dauert der Vorreinigungsschritt mindestens 1 s und maximal 15 s.

Besonders bevorzugt wird die Vorderseite der Halbleiterscheibe horizontal ausgerichtet ist und rotiert während des Vorreinigungsschrittes mit einer Geschwindigkeit von größer als 500 U/min und kleiner als 1000 U/min.

Besonders bevorzugt wird zum Auftragen des Wassers im Vorreinigungsschritt eine Düse verwendet und die Düsenströmung beträgt dabei zwischen 0,5 m/s und 2 m/s, wobei der zugehörige Durchfluss zwischen 0,5 l/min und 1,5 l/min beträgt.

Besonders bevorzugt ist die verwendete Düse so ausgerichtet ist, dass die Richtung der Düsenströmung mit der Oberfläche der Halbleiterscheibe einen Winkel α bildet, der kleiner ist als 70° und größer ist als 30°.

Besonders bevorzugt ist, wenn der Vorreinigungsschritt mindestens 1 s und maximal 15 s dauert, ganz besonders bevorzugt dauert der Schritt mindestens 3 s und maximal 8 s.

Bevorzugt für das Verfahren ist es, wenn die Seite des Halbleiterscheibe, die gereinigt werden soll, horizontal ausgerichtet ist und während des Vorreinigungsschrittes mit einer Geschwindigkeit von größer als 500 U/min und kleiner als 1000 U/min rotiert.

Besonders bevorzugt ist es, wenn zum Auftragen des Wassers im Vorreinigungsschritt eine Düse verwendet wird. Die Düsenströmung beträgt dabei besonders bevorzugt zwischen 0,5 m/s und 2 m/s, wobei der zugehörige Durchfluss bevorzugt zwischen 0,5 l/min und 1,5 l/min beträgt.

Bevorzugt ist es ebenfalls dass die Düse so ausgerichtet ist, dass die Richtung der Düsenströmung mit der Oberfläche der Halbleiterscheibe einen Winkel α bildet, der kleiner ist als 70° und größer ist als 30°.

Eine besonders bevorzugte Ausprägung des erfinderischen Verfahrens zur Reinigung der Vorderseite ist in Tabelle 1 gezeigt.

**Tabelle 1**

| ***Schritt #*** | ***Seite*** | ***Bezeichnung*** | ***Medium*** | ***Konzentration*** | ***Dauer [s]*** |
|---|---|---|---|---|---|
| *0* | *Vorderseite* | *DIW* | *DIW* | | *3-8* |
| *1* | *Vorderseite* | *O3W* | *O₃+DIW* | *15-20 ppm* | *25* |
| *2* | *Vorderseite* | *DIW* | *DIW* | | *10* |
| *3* | *Vorderseite* | *SC1* | *TMAH + H₂O₂ + DIW* | *TMAH 0,3%, H₂O₂ 0,7%* | *20* |
| *4* | *Vorderseite* | *DIW* | *DIW* | | *20* |
| *5* | *Vorderseite*/ *Rückseite* | *O3W* | *O₃+DIW* | *15-20 ppm* | *20* |
| *6* | *Vorderseite*/ *Rückseite* | *HF* | *HF + DIW* | *0,5-1 %* | *3* |
| *7* | *Vorderseite*/ *Rückseite* | *O3W* | *O₃+D*/*W* | *15-20 ppm* | *20* |
| *8* | *Vorderseite*/ *Rückseite* | *HF* | *HF + DIW* | *0,5-1 %* | *3* |
| *9* | *Vorderseite*/ *Rückseite* | *O3W* | *O₃+DIW* | *15-20 ppm* | *20* |
| *10* | *Vorderseite*/ *Rückseite* | *HF* | *HF + DIW* | *0,5-1 %* | *3* |
| *11* | *Vorderseite*/ *Rückseite* | *O3W* | *O₃+DIW* | *15-20 ppm* | *20* |
| *12* | *Vorderseite*/ *Rückseite* | *DIW* | *DIW* | | *10* |
| *13* | *Vorderseite*/ *Rückseite* | *DRY* | *N₂* | | *26* |

## Patentansprüche

1. Verfahren zum Reinigen einer Vorderseite und einer Rückseite einer Halbleiterscheibe umfassend in gegebener Reihenfolge:
die Reinigung der Vorderseite der Halbleiterscheibe enthaltend in gegebener Reihenfolge:
(1) Vorreinigungsschritt mit Wasser, so dass die Vorderseite noch nass ist, während der nächste Reinigungsschritt beginnt
(2) ein erster Reinigungsschritt zum Reinigen mit ozonisiertem Wasser und anschließendem Spülschritt mit gereinigtem Wasser,
(3) ein zweiter Reinigungsschritt, der einen Behandlungsschritt mit ozonisiertem Wasser enthält, der gefolgt wird von einem Behandlungsschritt mit einer HF enthaltenden Flüssigkeit,
(4) ein dritter Reinigungsschritt zum Reinigen mit ozonisiertem Wasser und anschließendem Spülschritt mit gereinigtem Wasser,
die gemeinsame Reinigung der Vorderseite und der Rückseite der Halbleiterscheibe enthaltend:
einen vierten Reinigungsschritt, der einen Behandlungsschritt mit ozonisiertem Wasser enthält, der gefolgt wird von einem Behandlungsschritt mit einer HF enthaltenden Flüssigkeit,
und einen Trocknungsschritt, bei dem beide Seiten der Halbleiterscheibe getrocknet werden.

2. Verfahren nach Anspruch 1, **dadurch gekennzeichnet,**
**dass** der zweite Reinigungsschritt mehrfach wiederholt wird.

3. Verfahren nach Anspruch 1, **dadurch gekennzeichnet, dass** dem dritten Reinigungsschritt ein Trocknungsschritt folgt, bei dem die Vorderseite der Halbleiterscheibe getrocknet wird.

4. Verfahren nach Anspruch 1,**dadurch gekennzeichnet, dass** der vierte Reinigungsschritt mehrfach wiederholt wird.

5. Verfahren nach Anspruch 1,**dadurch gekennzeichnet, dass** der vierte Reinigungsschritt mehr als dreimal wiederholt wird.

## Claims

1. Method for cleaning a facing side and a reverse side of a semiconductor wafer, comprising, in the order given:
the cleaning of the facing side of the semiconductor wafer, containing, in the order given:
(1) a precleaning step with water, so that the facing side is still wet as the next cleaning step begins,
(2) a first cleaning step for cleaning with ozonized water and subsequent rinsing step with purified water,
(3) a second cleaning step, which contains a treatment step with ozonized water followed by a treatment step with a liquid containing HF,
(4) a third cleaning step for cleaning with ozonized water and subsequent rinsing step with purified water,
the joint cleaning of the facing side and the reverse side of the semiconductor wafer, containing:
a fourth cleaning step, which contains a treatment step with ozonized water followed by a treatment step with a liquid containing HF,
and a drying step, in which both sides of the semiconductor wafer are dried.

2. Method according to Claim 1, **characterized in that** the second cleaning step is repeated multiply.

3. Method according to Claim 1, **characterized in that** the third cleaning step is followed by a drying step in which the facing side of the semiconductor wafer is dried.

4. Method according to Claim 1, **characterized in that** the fourth cleaning step is repeated multiply.

5. Method according to Claim 1, **characterized in that** the fourth cleaning step is repeated more than three times.

## Revendications

1. Procédé de nettoyage d'une face avant et d'une face arrière d'une plaquette semi-conductrice comprenant dans l'ordre donné :
le nettoyage de la face avant de la plaquette semi-conductrice contenant dans l'ordre donné :
(1) une étape de pré-nettoyage avec de l'eau, de telle sorte que la face avant reste humide pendant que l'étape de nettoyage suivante commence
(2) une première étape de nettoyage pour un nettoyage avec de l'eau ozonisée et par la suite une étape de rinçage avec l'eau purifiée,
(3) une deuxième étape de nettoyage, qui contient une étape de traitement par de l'eau ozonisée, qui est suivie par une étape de traitement avec un liquide contenant du HF,
(4) une troisième étape de nettoyage pour un nettoyage avec de l'eau ozonisée et par la suite une étape de rinçage avec de l'eau purifiée,
le nettoyage conjoint de la face avant et de la face arrière de la plaquette semi-conductrice contenant :
une quatrième étape de nettoyage, qui contient une étape de traitement avec de l'eau ozonisée, et par la suite une étape de traitement par un liquide contenant du HF,
et une étape de séchage durant laquelle les deux faces de la plaquette semi-conductrice sont séchées.

2. Procédé selon la revendication 1, **caractérisé en ce que** la deuxième étape de nettoyage est répétée plusieurs fois.

3. Procédé selon la revendication 1, **caractérisé en ce que** la troisième étape de nettoyage est suivie d'une étape de séchage durant laquelle la face avant de la plaquette semi-conductrice est séchée.

4. Procédé selon la revendication 1, **caractérisé en ce que** la quatrième étape de nettoyage est répétée plusieurs fois.

5. Procédé selon la revendication 1,**caractérisé en ce que** la quatrième étape de nettoyage est répétée plus de trois fois.
